# EUROPÄISCHE PATENTSCHRIFT

(11) **EP 1 350 420 B1**
(45) Veröffentlichungstag und Bekanntmachung des Hinweises auf die Patenterteilung: **13.10.2004**
(21) Anmeldenummer: 02701169.1
(22) Anmeldetag: 07.01.2002
(51) Int. Cl.: H05K 13/04

(54) **EINRICHTUNG ZUR POSITIONIERUNG EINER BAUELEMENTEAUFNAHMEEINHEIT EINES BESTÜCKAUTOMATEN FÜR LEITERPLATTEN**
DEVICE FOR POSITIONING A COMPONENT PICKING UNIT OF A PCB ASSEMBLY MACHINE FOR PRINTED CIRCUIT BOARDS
DISPOSITIF DE POSITIONNEMENT D'UNE UNITE DE RECEPTION DE COMPOSANTS D'UN AUTOMATE D'IMPLANTATION DE COMPOSANTS DESTINE A DES PLAQUETTES DE CIRCUITS IMPRIMES

(30) Priorität: 09.01.2001 DE 10100619
(43) Veröffentlichungstag der Anmeldung: 08.10.2003
(73) Patentinhaber: Siemens Aktiengesellschaft, 80333 München (DE)
(72) Erfinder: PRÜFER, Martin, 81379 München (DE)
(86) Internationale Anmeldenummer: PCT/DE2002/000019
(87) Internationale Veröffentlichungsnummer: WO 2002/056664

(56) Entgegenhaltungen:
- WO-A-91/11093
- US-A- 4 809 430
- US-A- 5 864 944

## Beschreibung

Die vorliegende Erfindung betrifft eine Einrichtung zur Positionierung der Bauelementeaufnahmeeinheit eines Bestückautomaten für Leiterplatten, bei der die Drehpositionierung einer zur Aufnahme eines Bauelements dienenden Saugpipette mit Hilfe einer Inkrementalgeberanordnung stattfindet, die im wesentlichen aus einem ortsfesten Lesekopf und einer drehbaren Segmentscheibe besteht, welche eine Inkrementalspur zur Messung eines gefahrenen Drehwinkels für die Feinpositionierung sowie eine aus zwei in gegenüberliegenden Quadranten der Segmentscheibe angeordneten Vollspuren zur raschen Bewegung in eine Ausgangsposition der Saugpipette für die Aufnahme eines Bauelements aufweist.

In allgemein bekannter Weise erfolgt bei einem Bestückautomaten der hier interessierenden Art der Transport eines elektronischen Bauelements mittels einer Bauelementeaufnahmeeinheit, die ein Bauelement von einer Bauelementespeichereinheit zu einer zu bestückenden Leiterplatte mittels mindestens einer über eine Pinole bewegbaren Saugpipette durchführt. Die Bauelementeaufnahmeeinheit umfasst beispielsweise einen 6- oder 12-Segment-Revolverkopf mit horizontaler Drehachse, der an einem Portalachsensystem mit Linearmotoren angebracht ist, um die Leiterplattenbestückung nach dem Collect&Place-Prinzip vorzunehmen. Daneben sind auch Bauelementeaufnahmeeinheiten bekannt, die sequentiell nach dem Pick&Place-Prinzip arbeiten und meist zur Bestückung größerer Bauelemente zum Einsatz kommen.

Eine Drehpositionierung der Saugpipette erfolgt bei einer gattungsgemäßen Einrichtung mit Hilfe einer Inkrementalgeberanordnung. Die dazugehörige Segmentscheibe weist eine Inkrementalspur auf, über die mittels eines Encoders die durchfahrenden Winkelinkremente ermittelbar sind. Diese Spurinformation wird zur inkrementellen Positionierung verwendet. Weiterhin ist eine innere, in gegenüberliegenden Quadranten der Segmentscheibe angeordnete Vollspur vorgesehen, d. h. es existieren insoweit zusätzlich zwei gegenüberliegende Kreisbogensegmente zu je 90°. Diese beiden Kreisbogensegmente werden für ein schnelles Vordrehen in die gewünschte Ausgangsposition der Saugpipette zum Abholen eines Bauelements verwendet. Aufgrund dieser Anordnung der Vollspur kann die Abholorientierung der Saugpipette im Winkel von +/- 180° variieren, da lediglich der Bereich von 0° bis 180° definiert ist und der übrige Bereich von 180° bis 360° wieder als Bereich von 0° bis 180° interpretiert wird. Bei achssymmetrischen Saugpipetten und ideal ausgerichteter Pinole ist diese Lageinterpretation hinnehmbar und ermöglicht aus signalverarbeitungstechnischen Gründen ein besonders schnelles Vordrehen der Saugpipette.

Im Zuge der zunehmenden Miniaturisierung der Bauelemente treten allerdings Maßtoleranzen an Elementen der Bauelementeaufnahmeeinheit stärker in den Vordergrund. Insbesondere beim Abholen eines kleinen Bauelements (z.B. GF 0201) aus der Bauelementespeichereinheit ist die Saugpipette genau gegenüber dem kleinen Bauelement zu positionieren.

Wie die Praxis zeigte, führen Lage- und Maßhaltigkeitsabweichungen im Bereich der Saugpipette bei zunehmender Miniaturisierung der Bauelemente zu einer steigenden Fehlerquote beim Abholen. So treten konkret Abweichungen in der Achssymmetrie zwischen der Saugpipette und der Pinole auf, beispielsweise durch eine Pinolenverbiegung, eine nicht festsitzende Saugpipette oder aufgrund von Fertigungstoleranzen der Saugpipette oder dergleichen. Es lässt sich auch nicht ausschließen, dass die Segmentscheibe eine leichte Verbiegung aufweist. In Folge all dieser Gründe können die Achse der Saugpipette und die optische Drehachse derart auseinanderliegen, dass bei einer Variation der Winkelorientierung der Saugpipette um +/- 180° keine zuverlässige Aufnahme eines kleinen Bauelements mehr möglich ist.

Aus der WO 91/11 093 ist eine Einrichtung zur Positionierung der Bauelemente aufnahmeeinheit eines Bestückautomaten für Leiterplalten bekannt, bei der die Drehpositionierung einen zur Aufnahme eines Bauelements dienenden Saugpipelte mit Hilfe einer Inkrementalgeberanordnung stattfindet, die aus einem ortsfesten Lesekopf und einer diehbaren Segmentscheibe besteht, welche eine Inkrementalspur zur Messung eines gefahrenen Drehwinkels für die Feinpositionierung aufweist.

Aus der WO 99/49713 ist ein Verfahren und eine Vorrichtung zur Lagebestimmung eines Bauelements bezüglich der Saugpipette einer Bauelementeaufnahmeeinheit bekannt. Es ist hier jedoch mit Hilfe eines optischen Sensors im Zusammenwirken mit einer Lichtquelle lediglich nach dem Abholen des Bauelements, dessen Vorhandensein an der Saugpipette ermittelbar, um eine fehlerhaft erfolgte Aufnahme erkennen zu können.

Dagegen ist es die Aufgabe der vorliegenden Erfindung eine Einrichtung zur Lagebestimmung der Saugpipette einer Bauelementeaufnahmeeinheit zu schaffen, die bereits beim Abholen des Bauelements eine reproduzierbare Winkelorientierung zulässt, um eine genaue Positionierung der Saugpipette zu ermöglichen.

Die Aufgabe wird ausgehend von einer Einrichtung gemäß dem Oberbegriff des Anspruchs 1 in Verbindung mit dessen kennzeichnenden Merkmalen gelöst. Die nachfolgenden abhängigen Ansprüche geben vorteilhafte Weiterbildungen der Erfindung wieder.

Die Erfindung schließt die technische Lehre ein, dass eine gattungsgemäße Segmentscheibe ergänzend zu den Vollspuren mit einer zusätzlichen Markierung versehen ist, um mittels der Inkrementalgeberanordnung eine reproduzierbare Winkelorientierung der Saugpipette bezüglich der Ausgangsposition zum Aufnehmen des Bauelements zu gewährleisten.

Der Vorteil liegt insbesondere in der durch die zusätzliche Markierung auf einfache Weise gewonnenen zusätzlichen Information für eine eindeutige Positionierung der Saugpipette. Es ist nunmehr beim raschen Bewegen in die Ausgangsposition der Saugpipette eine Unterscheidung der Winkelposition im gesamten Bereich von 0° bis 360° möglich. Mit der damit gewonnenen reproduzierbaren Abholorientierung der Saugpipette können Lage- und Maßhaltigkeitsabweichungen im Bereich der Saugpipette beim Positionieren Berücksichtigung finden, so dass eine geringere Fehlerquote beim Abholen insbesondere eines kleinen Bauelements erzielbar ist.

Erfindungsgemäß kann die zusätzliche Markierung auf der Segmentscheibe in drei bevorzugten Ausführungsformen angebracht werden. So ist es denkbar, die zusätzliche Markierung in Form einer dritten, in einem radialen Abstand neben den beiden Vollspuren verlaufenden Spur auszubilden, die über einen zu den beiden gegenüberliegenden Quadranten benachbarten Quadranten verläuft. Die Spuren können beispielsweise kreisbogenförmig als dicke Linie ausgebildet sein oder auch ein ganzes Kreissegment einnehmen. Da aber lediglich eine Information im Grenzbereich zu einem benachbarten Quadranten benötigt wird, um eine reproduzierbare Winkelorientierung zu gewährleisten, ist es auch ausreichend, wenn die zusätzliche Markierung nur in Form von zwei, neben den beiden Vollspuren in einem radialen Abstand verlaufenden Spurteilen ausgebildet wird, die je nur über den Grenzbereich eines zu den beiden gegenüberliegenden Quadranten benachbarten Quadranten verlaufen. Die Spurenteile können strichförmig, punktförmig, ellipsenförmig oder auf eine andere geeignete Weise ausgebildet sein.

Die zusätzliche Markierung kann bei den beiden vorgenannten Ausführungsformen wegen des radialen Abstandes zu den Vollspuren von der Signalverarbeitung ausgeblendet werden, so dass ein Betrieb sowohl mit reproduzierbarer Winkelorientierung als auch ohne diese wahlweise möglich ist. Da bei größeren Bauelementen die Lage- und Maßhaltigkeitsabweichungen im Bereich der Saugpipette nicht in dem Maße kritisch sind wie bei kleinen Bauelementen, kann hier auch ein vergleichsweise schnellerer Betrieb ohne reproduzierbare Winkelorientierung gewählt werden.

Die zusätzliche Markierung kann nach einer letzten bevorzugten Ausführungsform auch als ein die beiden Vollspuren über einen benachbarten Quadranten hinweg verbindenden Spurteil ausgebildet sein. Insoweit entsteht eine durchgehende Spur mit einem Winkel von 270° oder - invertiert gesehen - von 90°. Hier ist zwar ein Ausblenden der Winkelorientierungsinformation wegen des Fehlens eines radialen Abstandes zu den beiden gegenüberliegenden Vollspuren nicht möglich; gleichwohl sind durch diese Variante keine Änderungen am Lesekopf durch Hinzufügen eines dritten Spursensors erforderlich, so dass bereits bestehende Bauelementeaufnahmeeinheiten ohne viel Aufwand auf eine reproduzierbare Winkelorientierung durch einfaches Umstellen der Signalverarbeitungssoftware umrüstbar sind.

Um eine hohe Positioniergenauigkeit zu erzielen ist es vorteilhaft, wenn die beiden Vollspuren mit den zusätzlichen Markierungen bezüglich der Inkrementalspur auf einen kleineren Radius der Segmentscheibe angeordnet sind. Damit kann für die Inkrementalspur eine höchstmögliche Auflösung gewährleistet werden.

Weitere die Erfindung verbessernde Maßnahmen werden nachfolgend gemeinsam mit der Beschreibung bevorzugter Ausführungsbeispiele der Erfindung anhand der Figuren näher dargestellt. Es zeigt:
- Figur 1: eine Seitenansicht einer erfindungsgemäß positionierbaren Bauelementeaufnahmeeinheit eines Bestückautomaten,
- Figur 2: eine Seitenansicht einer an einer Pinole angeordneten Saugpipette,
- Figur 3a: eine Draufsicht auf eine erfindungsgemäß ausgebildete Segmentscheibe in einer ersten Ausführungsform,
- Figur 3b: eine Draufsicht auf eine erfindungsgemäß ausgebildete Segmentscheibe in einer zweiten Ausführungsform,
- Figur 3c: eine Draufsicht auf eine erfindungsgemäß ausgebildete Segmentscheibe in einer dritten Ausführungsform,

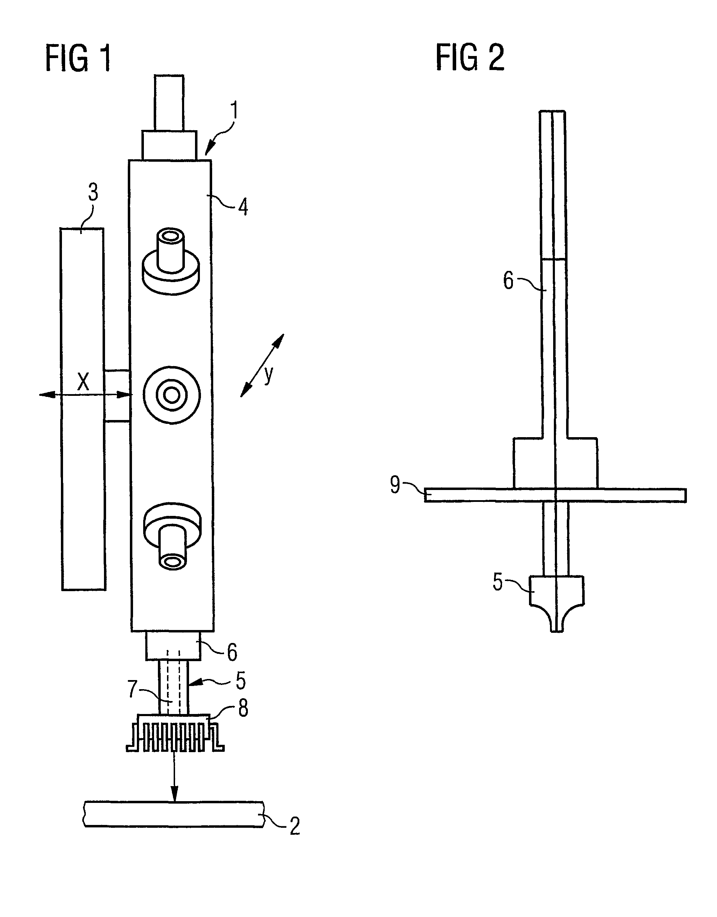

Gemäß des Ausführungsbeispieles nach Fig.1 ist eine Bauelementeaufnahmeeinheit 1 eines Bestückautomaten für Leiterplatten 2 nach Art eines 12-Segment-Revolverkopfes mit horizontaler Drehachse ausgebildet, der an einem (nicht weiter gezeigtem) Portalachsensystem in X- und Y-Richtung bewegbar ist. Die Bauelementeaufnahmeeinheit 1 besteht aus einem mit dem Portalachsensystem in Verbindung stehenden Stator 3 und einem an diesem drehbar gelagerten Rotor 4. Der Rotor 4 weist sternförmig abstehende Saugpipetten 5 auf, die von drehsymmetrisch angeordneten Pinolen 6 austauschbar gehalten sind. Durch die Saugpipette 5 wird mittels eines innenliegend längsverlaufenden Luftkanals 7 ein Bauelement 8 durch Ansaugen gehalten, um dieses zu transportieren. Die mit den Saugpipetten 5 des Rotors 4 gesammelten Bauelemente 8 können durch indiziertes Drehen des Rotors 4 entsprechend der Segmentteilung sukzessive in ihre jeweilige Aufsetzposition über der Leiterplatte 2 verdreht werden. Zur individuellen Drehpositionierung jeder Saugpipette 5 um ihre eigene Achse ist eine Inkrementalgeberanordnung vorgesehen.

Gemäß Figur 2 umfasst die Inkrementalgeberanordnung eine drehbare Segmentscheibe 9, die koaxial an der Pinole 6 angebracht ist. Die Segmentscheibe 9 arbeitet mit einem (hier nicht weiter dargestellten) Lesekopf zusammen, um die Positionierung der Saugpipette 5 vorzunehmen. Die Pinole 6 ist Bestandteil des Rotors 4 und dient der Befestigung und Längssowie Drehbewegung der Saugpipette 5.

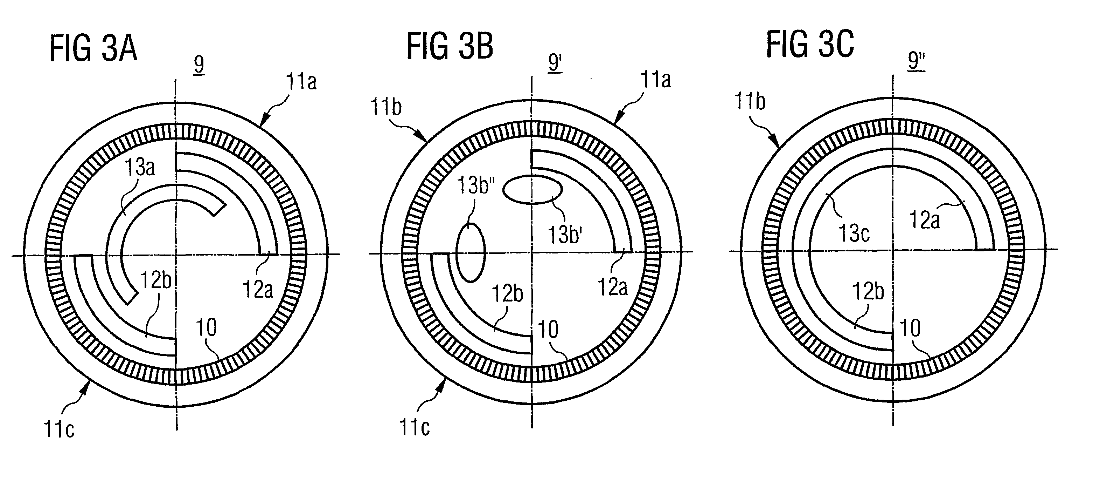

Die Segmentscheibe 9 besitzt gemäß Fig. 3a eine Inkrementalspur 10 zur Messung eines gefahrenen Drehwinkels für die Feinpositionierung sowie eine aus zwei in gegenüberliegenden Quadranten 11a und 11c der Segmentscheibe 9 angeordneten Vollspuren 12a und 12b, die zur raschen Drehbewegung in eine Ausgangsposition der Saugpipette 5 für die Aufnahme eines Bauelements dienen. Weiterhin ist die Segmentscheibe 9 ergänzend zu den Vollspuren 12a und 12b mit einer zusätzlichen Markierung 13a versehen, um mittels der Inkrementalgeberanordnung eine reproduzierbare Winkelorientierung der Saugpipette 5 bezüglich der Ausgangsposition zu gewährleisten.

Alternativ hierzu kann nach Fig. 3b die Segmentscheibe 9' auch mit einer zusätzlichen Markierung 13b' und 13b'' in Form von zwei, neben den beiden Vollspuren 12a und 12b in einem radialen Abstand verlaufenden Spurteilen ausgebildet sein. Die Spurteile verlaufen in diesem Fall je nur über den Grenzbereich eines zu den beiden gegenüberliegenden Quadranten 11a, 11c benachbarten Quadranten 11b.

Nach einer weiteren Ausführungsform gemäß Fig. 3c ist auf der Segmentscheibe 9'' die zusätzliche Markierung 13c in Form eines die beiden Vollspuren 12a und 12b über einen benachbarten Quadranten 11b hinweg verbindenden Spurteils ausgebildet ist. Dieser Spurteil verläuft im gleichen radialen Abstand zu den Vollspuren 12a und 12b, so dass sich insgesamt ein durchgezogener Dreiviertelkreis bildet.

## Patentansprüche

1. Einrichtung zur Positionierung der Bauelementeaufnahmeeinheit (1) eines Bestückautomaten für Leiterplatten (2), bei der die Drehpositionierung einer zur Aufnahme eines Bauelements (8) dienenden Saugpipette (5) mit Hilfe einer Inkrementalgeberanordnung stattfindet, die im wesentlichen aus einem ortsfesten Lesekopf und einer drehbaren Segmentscheibe (9) besteht, welche eine Inkrementalspur (10) zur Messung eines gefahrenen Drehwinkels für die Feinpositionierung sowie eine aus zwei in gegenüberliegenden Quadranten (11a, 11c) der Segmentscheibe (9) angeordneten Vollspuren (12a, 12b) zur raschen Bewegung in eine Ausgangsposition der Saugpipette (5) für die Aufnahme eines Bauelements (8) aufweist,
**dadurch gekennzeichnet,**
**dass** die Segmentscheibe (9) ergänzend zu den Vollspuren (12a, 12b) mit einer zusätzlichen Markierung (13a; 13b',13b''; 13c) versehen ist, um mittels der Inkrementalgeberanordnung eine reproduzierbare Winkelorientierung der Saugpipette (5) bezüglich der Ausgangsposition zu gewährleisten.

2. Einrichtung nach Anspruch 1,
**dadurch gekennzeichnet,**
**dass** die zusätzliche Markierung (13a) in Form einer dritten, in einem radialen Abstand neben den beiden Vollspuren (12a, 12b) verlaufenden Spur ausgebildet ist, die über einen zu den beiden gegenüberliegenden Quadranten (11a, 11c) benachbarten Quadranten (11b) verläuft (Fig. 3a).

3. Einrichtung nach Anspruch 1,
**dadurch gekennzeichnet,**
**dass** die zusätzliche Markierung (13b' und 13b'') in Form von zwei, neben den beiden Vollspuren (12a, 12b) in einem radialen Abstand verlaufenden Spurteilen ausgebildet ist, die je nur über den Grenzbereich eines zu den beiden gegenüberliegenden Quadranten (11a, 11c) benachbarten Quadranten (11b) verlaufen (Fig. 3b).

4. Einrichtung nach Anspruch 1,
**dadurch gekennzeichnet,**
**dass** die zusätzliche Markierung (13c) in Form eines die beiden Vollspuren (12a, 12b) über einen benachbarten Quadranten (11b) hinweg verbindenden Spurteils ausgebildet ist, der im gleichen radialen Abstand zu den Vollspuren (12a, 12b) verläuft (Fig. 3c).

5. Einrichtung nach Anspruch 1,
**dadurch gekennzeichnet,**
**dass** die beiden Vollspuren (12a, 12b) sowie die zusätzliche Markierung (13a; 13b',13b''; 13c) bezüglich der Inkrementalspur (10) auf einem kleineren Radius der Segmentscheibe (9) angeordnet sind.

## Claims

1. Device for positioning the component pick-up unit (1) of a PCB assembly machine for printed circuit boards (2), in which the rotational positioning of a suction pipette (5) used to pick up a component (8) is carried out with the aid of an incremental encoder arrangement which substantially comprises a fixed-location read head and a rotatable segment disc (9) which has an incremental track (10) for measuring a rotational angle covered for the precise positioning and also one comprising two full tracks (12a, 12b) arranged in opposite quadrants (11a, 11c) of the segment disc (9) for the rapid movement into an initial position of the suction pipette (5) to pick up a component (8), **characterized in that**, as a supplement to the full tracks (12a, 12b), the segment disc (9) is provided with an additional marking (13a; 13b', 13b''; 13c) in order to ensure a reproducible angular orientation of the suction pipette (5) with respect to the initial position by means of the incremental encoder arrangement.

2. Device according to Claim 1, **characterized in that** the additional marking (13a) is constructed in the form of a third track which runs with a radial spacing beside the two full tracks (12a, 12b) and which runs over a quadrant (11b) adjacent to the two opposite quadrants (11a, 11c).

3. Device according to Claim 1, **characterized in that** the additional marking (13b' and 13b'') is constructed in the form of two track parts which run beside the two full tracks (12a, 12b) with a radial spacing and which run only over the limit region of a quadrant (11b) adjacent to the two opposite quadrants (11a, 11c).

4. Device according to Claim 1, **characterized in that** the additional marking (13c) is constructed in the form of a track part which connects the two full tracks (12a, 12b) over an adjacent quadrant (11b) and which runs with the same radial spacing from the full tracks (12a, 12b).

5. Device according to Claim 1, **characterized in that** the two full tracks (12a, 12b) and the additional marking (13a; 13b', 13b''; 13c) are arranged on a smaller radius of the segment disc (9) with respect to the incremental track (10).

## Revendications

1. Dispositif pour le positionnement de l'unité de réception des composantes (1) d'un automate d'équipement pour des circuits imprimés (2), dans lequel le positionnement en rotation d'une pipette aspirante (5) destinée à réceptionner une composante (8) a lieu à l'aide d'un agencement de transmetteurs incrémentaux, essentiellement constitué d'une tête de lecture stationnaire et d'un disque segmenté rotatif (9), muni d'une piste incrémentale (10) pour mesurer un angle de rotation parcouru pour le positionnement fin et d'une de deux pistes pleines (12a, 12b) disposées dans des quadrants opposés (11a, 11c) du disque segmenté (9), pour le déplacement rapide dans une position initiale de la pipette aspirante (5) pour la réception d'une composante (8), **caractérisé en ce qu'**en complément des pistes pleines (12a, 12b), le disque segmenté (9) est muni d'un marquage supplémentaire (13a ; 13b', 13b" ; 13c), pour garantir au moyen de l'agencement de transmetteurs incrémentaux une orientation angulaire reproductible de la pipette aspirante (5), par rapport à la position initiale.

2. Dispositif selon la revendication 1, **caractérisé en ce que** le marquage supplémentaire (13a) est conçu sous la forme d'une troisième piste passant à distance radiale à côté des deux pistes pleines (12a ; 12b), qui passe par-dessus un quadrant (11b) voisin des deux quadrants opposés (11a, 11c) (figure 3a).

3. Dispositif selon la revendication 1, **caractérisé en ce que** le marquage supplémentaire (13b' et 13b") est conçu sous forme de deux parties de piste passant à distance radiale à côté des deux pistes pleines (12a, 12b), dont chacune passe uniquement par-dessus la zone limite d'un quadrant (11b) voisin des deux quadrants opposés (11a, 11c) (figure 3b).

4. Dispositif selon la revendication 1, **caractérisé en ce que** le marquage supplémentaire (13c) est conçu sous forme d'une partie de piste reliant les deux pistes pleines (12a, 12b) par-dessus un quadrant voisin (11b), qui passe à la même distance radiale des pistes pleines (12a, 12b) (figure 3c).

5. Dispositif selon la revendication 1, **caractérisé en ce que** les deux pistes pleines (12a, 12b), ainsi que le marquage supplémentaire (13a ; 13b', 13b" ; 13c) sont disposés sur un plus petit rayon du disque segmenté (9), par rapport à la piste incrémentale (10).
